# FASCICULE DE BREVET EUROPEEN

(11) **EP 3 368 959 B1**
(45) Date de publication et mention de la délivrance du brevet: **15.07.2020**
(21) Numéro de dépôt: 16787801.6
(22) Date de dépôt: 25.10.2016
(51) Int. Cl.: H05K 7/14, G06F 1/20, H05K 7/20

(54) **EQUIPEMENT INFORMATIQUE AVEC BLOC D'ALIMENTATION ÉLECTRIQUE REFROIDI**
RECHNERSYSTEM MIT GEKÜHLTER ELEKTRISCHER STROMVERSORGUNGSEINHEIT
COMPUTER SYSTEM WITH COOLED ELECTRIC POWER SUPPLY UNIT

(30) Priorité: 26.10.2015 FR 1560205
(43) Date de publication de la demande: 05.09.2018
(73) Titulaire: Calyos SA, 6040 Jumet (BE)
(72) Inventeur: DUPONT, Vincent, 1160 Auderghem (BE); DEPRET, Nicolas, 6221 Saint Amand (BE)
(74) Mandataire: Plasseraud IP
(86) Numéro de dépôt international: PCT/EP2016/075612
(87) Numéro de publication internationale: WO 2017/072095

(56) Documents cités:
- US-A1- 2012 279 686
- US-A1- 2014 216 686
- US-A1- 2015 296 661

## Description

La présente invention est relative aux équipements informatiques et/ou électroniques ; particulièrement, on s'intéresse à différents types de modules ou ensembles de serveurs informatiques qui sont habituellement employés dans des 'data centers' (se dirait en français 'centre de données/calcul') .

Le développement des échanges de données par le réseau internet a entrainé un besoin énorme de puissance de calcul et de stockage dans les serveurs permettant de répondre aux besoins des utilisateurs et en particulier ces serveurs sont souvent regroupés dans des centres appelés 'data centers'.

Les besoins de refroidissement des équipements électroniques/informatiques formant les ensembles serveurs dans ces 'data centers' ne cessent de croître en raison de la densité toujours plus élevée des processeurs dans ces cartes.

Il a déjà été proposé de prélever des calories sur les processeurs qui sont les sources les plus importantes d'échauffement dissipation au moyen d'un système de transfert thermique à changement de phase, comme par exemple dans le document US7770630.

Par ailleurs, il est connu, par exemple du document US2011132579, une solution dite de « *pool boiling* » dans laquelle tous les composants d'une carte électronique, y compris par conséquent les composants les plus dissipatifs sont immergés dans un liquide diélectrique qui forme le vecteur d'évacuation des calories. Cependant cette solution implique une quantité importante de liquide diélectrique, donc un coût élevé et par ailleurs induit de multiples risques de fuite ; ce qui rend préférable le traitement local et particulier des composants les plus dissipatifs. Par ailleurs dans la solution dite de « *pool boiling* », la source froide du système doit être nécessairement située au-dessus du niveau du liquide.

US2014216686 A1 divulgue un système d'immersion d'équipement informatique dans un fluide afin de refroidir cet équipement. US2015296661 A1 divulgue un dissipateur thermique plongé dans un liquide de refroidissement.

Il s'avère qu'un équipement informatique et/ou électronique est alimenté électriquement par un bloc d'alimentation électrique, en charge de générer une ou plusieurs alimentations stabilisées à partir de la tension alternative du réseau, qui lui aussi contient de nombreux composants dissipatifs, comme par exemple des diodes de redressement et des bobinages/self de lissage.

L'accroissement de la densité et de puissance de calcul conduit à prévoir un refroidissement performant du bloc d'alimentation électrique, qui est conventionnellement assuré par un ventilateur (ou en convection naturelle) au détriment de la compacité.

Par ailleurs, il est habituel de prévoir que le bloc d'alimentation électrique soit un élément remplaçable, en effet certains de ces composants peuvent tomber en panne car la technologie est choisie en fonction de son coût et de sa disponibilité sur le marché. Le surcoût qui permettrait de garantir une durée de vie comparable à celle de la partie calcul n'est pas acceptable à l'échelle du data center. Il n'est pas non plus exclu que le bloc d'alimentation électrique soit endommagé par une surtension sur le réseau électrique qui l'alimente.

Il s'avère que les solutions connues, notamment à base de ventilateur, ne répondent pas correctement à ce besoin. Il est donc apparu un besoin de proposer de nouvelles solutions pour assurer un refroidissement performant du bloc d'alimentation électrique tout en autorisant son remplacement, et au passage en améliorant la compacité.

A cet effet, ce document propose un équipement électronique et/ou informatique, comprenant :
- une ou plusieurs cartes électroniques et le cas échéant des éléments auxiliaires,
- un bloc d'alimentation électrique, équipé d'une **zone d'échange thermique,** qui fournit des alimentations électriques à différentes entités de l'équipement, le bloc d'alimentation électrique ayant une enveloppe étanche aux fluides définissant un espace intérieur empli de fluide diélectrique, apte à capter des calories sur divers composants du bloc d'alimentation électrique pour les diffuser vers la zone d'échange thermique, le bloc d'alimentation électrique étant démontable et remplaçable, - un circuit de transfert thermique diphasique à pompage capillaire avec un échangeur-absorbeur couplé thermiquement à la zone d'échange thermique du bloc d'alimentation électrique, et un échangeur-rejeteur, situé à distance du bloc d'alimentation électrique, et couplé thermiquement à un collecteur général de calories, caractérisé en ce que dans la position de service, la zone d'échange thermique est plaquée contre l'échangeur-absorbeur.

Ainsi, on assure un bon contact thermique entre le bloc d'alimentation électrique et le circuit de transfert thermique diphasique ; on peut ainsi évacuer les calories générées par le bloc d'alimentation électrique à distance de ce dernier de façon très efficace et passive. On comprend en effet que l'échangeur-absorbeur prélève des calories sur le bloc d'alimentation électrique et que l'échangeur-rejeteur rejette ces calories à distance. On note aussi que selon une des configurations possibles, l'échangeur-absorbeur sera formé par un évaporateur et l'échangeur-absorbeur sera formé par un condenseur (avec ou sans sous refroidissement 'sub-cooling').

Grâce à ces dispositions, on obtient une configuration avantageuse avec un bloc d'alimentation électrique remplaçable et efficacement refroidi. De plus, la suppression d'un ventilateur permet d'améliorer la compacité du bloc d'alimentation électrique ; par ailleurs la solution proposée permet d'augmenter la durée de vie et la fiabilité car le risque d'encrassement est éliminé même en environnement difficile pour des systèmes décentralisés (atmosphère non propre, poussiéreuse).

L'invention est définie par la revendication indépendante, des aspects supplémentaires de l'invention sont décrits dans les revendications dépendantes. Les modes de réalisation qui ne font pas partie de l'étendue de ces revendications ne décrivent pas l'invention. Dans des modes de réalisation du système selon ce document, on peut éventuellement avoir recours en outre à l'une et/ou à l'autre des dispositions suivantes.

Selon un aspect avantageux, le circuit de transfert thermique diphasique comprend un couple de deux conduites souples reliant l'échangeur-absorbeur et l'échangeur-rejeteur. Moyennant quoi, grâce à la souplesse desdites conduites, l'échangeur-absorbeur peut être facilement déplacé, pour l'éloigner de la zone d'échange thermique du bloc d'alimentation électrique, afin de libérer le déplacement du bloc d'alimentation électrique lors d'une opération de maintenance ou de remplacement.

Le couple de deux conduites peut comprendre une conduite vapeur et une conduite liquide. En particulier, on met à profit un phénomène de vaporisation dans l'échangeur absorbeur, ce qui permet de collecter très efficacement les calories sur le bloc d'alimentation électrique.

La zone d'échange thermique est typiquement formée par une ou plusieurs parois d'échange thermique, formant une part de l'enveloppe étanche ; de sorte qu'il suffit de plaquer l'échangeur-absorbeur sur la paroi d'échange thermique pour prélever les calories émises par le bloc d'alimentation électrique.

On prévoit avantageusement un matériau d'interface thermique favorisant la conduction thermique entre la paroi d'échange thermique et l'échangeur absorbeur. On peut ainsi diminuer la résistance thermique de contact et améliorer encore le transfert de calories depuis le bloc d'alimentation électrique jusqu'à l'échangeur absorbeur.

L'échangeur-absorbeur peut être un évaporateur dans lequel un fluide de travail diphasique est vaporisé par la chaleur apportée par la zone d'échange thermique. Le changement de phase permet de prélever une quantité importante de calories sur une surface limitée.

L'évaporateur peut comprendre une masse poreuse assurant la fonction de pompage capillaire ('mèche capillaire'). De sorte qu'on dispose d'un moyen local fournissant la fonction de pompage, indépendamment des moyens de circulation du fluide diphasique par ailleurs.

L'échangeur l'échangeur-absorbeur peut être situé au-dessus de l'échangeur-rejeteur, la force motrice de pompage étant fournie par la pression capillaire à l'encontre de la gravité. Grâce aux performances de la mèche capillaire, le fluide diphasique en phase liquide peut être pompé à l'encontre de la gravité depuis l'échangeur-rejeteur (condenseur) de manière passive. Cette caractéristique permet l'intégration aisée du système et de sa source froide dans le rack contrairement aux systèmes de type thermosiphons pour lesquels l'échangeur-rejeteur doit être situé au-dessus de la zone de vaporisation.

La zone d'échange thermique peut comprendre, du côté dirigé vers l'intérieur de l'espace intérieur, une surface d'échange thermique améliorée, de préférence sous forme de saillies ou extensions de la paroi solide, par exemple de type ailettes d'échange thermique ; on maximise ainsi l'aire disponible pour un bon échange thermique entre le fluide diélectrique et la zone d'échange thermique.

Selon une configuration, l'équipement électronique et/ou informatique se présente sous la forme d'un module carte serveur informatique pour centre de données/calcul, le bloc d'alimentation électrique ayant une forme générale parallélépipédique, reçu dans une glissière à l'intérieur d'une enveloppe du module, la zone d'échange thermique étant formée par au moins une paroi d'échange thermique.

Le bloc d'alimentation électrique peut être déplaçable entre une position de service et une position extraite pour procéder à son remplacement ou à sa maintenance. La paroi d'échange thermique s'étend dans un plan XY et on prévoit un mouvement selon la direction Z en fin de course d'insertion selon X à proximité de la position de service, la glissière étant généralement perpendiculaire à Z ; on peut ainsi rendre automatique le couplage entre la paroi d'échange thermique et l'échangeur-absorbeur en fin de course d'insertion du bloc d'alimentation électrique.

Le collecteur général de calories peut être un circuit de liquide froid commun, ce circuit étant avantageusement commun à plusieurs ensembles informatiques adjacents.

On peut prévoir une fixation de type clampage direct par vis rapides pour fixer l'échangeur-absorbeur contre la paroi d'échange thermique.

Optionnellement, on peut prévoir une interface détachable (IF2) entre l'échangeur-rejeteur et le collecteur général de calories.

D'autres caractéristiques et avantages de l'invention apparaîtront au cours de la description suivante d'une de ses formes de réalisation, donnée à titre d'exemple non limitatif, en regard des dessins joints.
- la figure 1 est une vue générale schématique d'un équipement électronique ou informatique avec un système de refroidissement comprenant un bloc d'alimentation électrique refroidi en mode *'pool boiling'* et en cascade par une boucle diphasique,
- la figure 2 est une vue générale en perspective de la zone arrière d'un module de carte serveur, selon une autre configuration, avec un bloc d'alimentation électrique extractible,
- la figure 3 montre en coupe transversale un module de carte serveur,
- la figure 4 est une autre vue générale en perspective d'un module de carte serveur,
- la figure 5 est analogue à la figure 1 et illustre trois variantes,
- la figure 6 montre plus en détail l'évaporateur capillaire en coupe
- la figure 7 est analogue à la figure 2 illustre une variante,
- la figure 8 montre en coupe le bloc d'alimentation électrique selon une variante,
- la figure 9 montre une vue d'une armoire serveur informatique.

Sur les différentes figures, les mêmes références désignent des éléments identiques ou similaires.

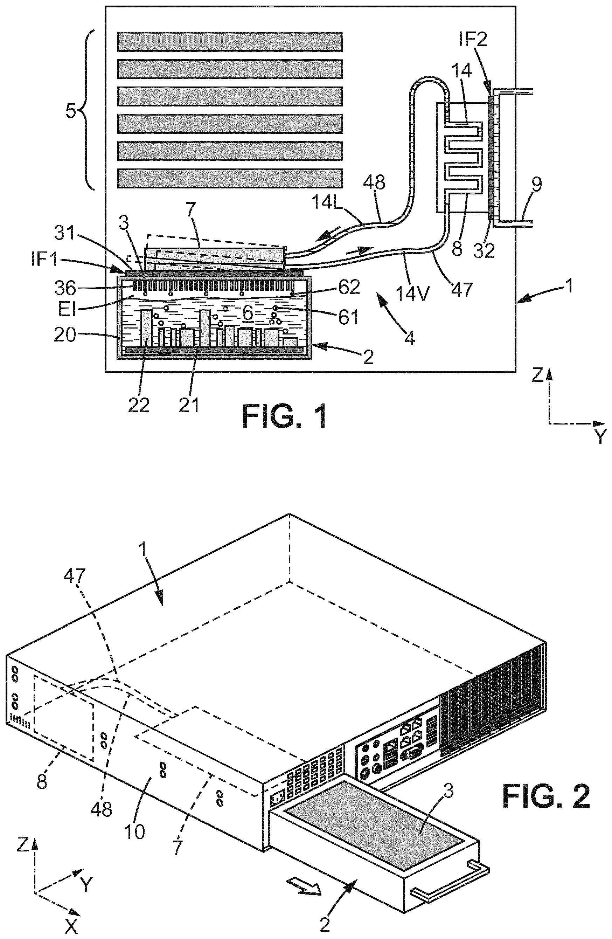

La figure 1 représente schématiquement un exemple d'un équipement électronique ou informatique **1** avec un bloc d'alimentation électrique **2** extractible. Un exemple type d'un tel équipement informatique est un rack (une 'armoire') de serveur(s) informatique répondant à des requêtes sur Internet.

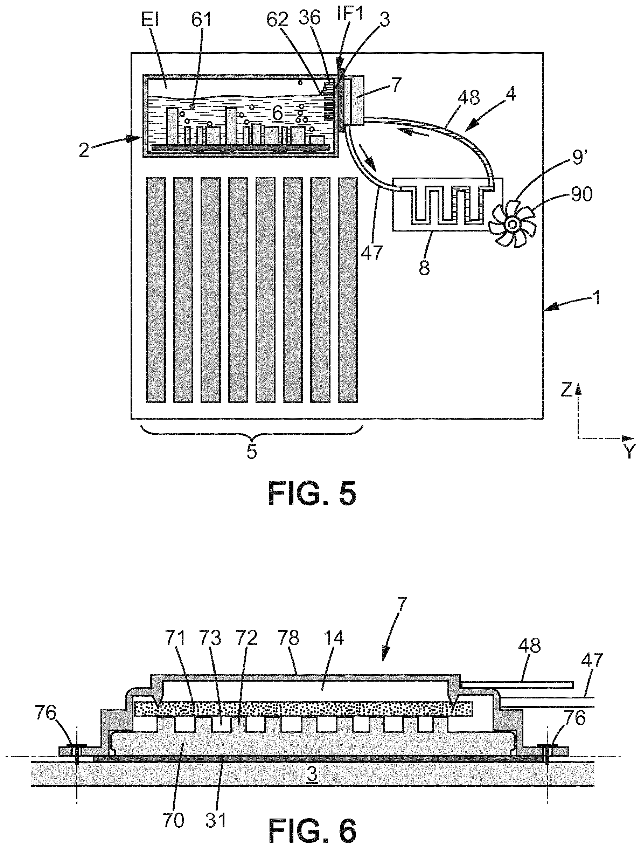

Ce type d'équipement électronique ou informatique comprend habituellement une ou plusieurs cartes électroniques **5** reçues dans des glissières. La disposition de ces cartes électroniques peut être horizontale (Fig. 1) ou verticale (Fig. 5). Dans certains cas, ces cartes électroniques 5 peuvent être relativement simples, sans enveloppe de protection ; dans d'autres cas, ces cartes électroniques peuvent être plus élaborées avec une enveloppe de protection et une combinaison de carte mère et de carte(s) fille(s), sans exclure la présence de disques durs ou d'entités de stockage mémoire, de modules couplage au réseau Internet, etc..

S'agissant des alimentations électriques nécessaires au fonctionnement de ces cartes électroniques, il est habituellement prévu une entité dédiée, appelée 'bloc d'alimentation électrique', qui fournit différentes alimentations électriques stabilisées. Selon une configuration, on prévoit un bloc d'alimentation électrique 2 commun à une pluralité de cartes électroniques (Figs. 1 et 5). Selon une autre configuration, dans le cas de cartes électroniques complexes, le bloc d'alimentation électrique peut être embarqué avec la carte électronique elle-même (Figs. 2,3,4 et 7).

Comme énoncé dans l'introduction, en raison de l'accroissement de la puissance de calcul, le bloc d'alimentation électrique doit être refroidi de façon de plus en plus efficace, ce qui est fait est conventionnellement au moyen d'une convection à air par ventilateur. La solution du ventilateur présente l'inconvénient d'un encombrement minimal nécessaire pour un flux d'air efficace. Par ailleurs, il est connu que les radiateurs à ailettes peuvent piéger de la poussière ce qui diminue au cours du temps l'efficacité de la solution à ventilateur. En outre, le ventilateur fait du bruit et ce dernier a tendance à augmenter avec le temps, de plus la durée de vie du ventilateur est forcément bornée.

Avantageusement selon la présente invention, on utilise une technique de refroidissement essentiellement liquide pour refroidir le substrat **21** et les différents composants **22** qui sont inclus dans le bloc d'alimentation électrique. Pour ce faire, le bloc d'alimentation électrique **2** comprend une enveloppe étanche aux fluides **20** définissant un espace intérieur **EI** empli d'un fluide diélectrique **6.** Pour éviter tout risque de montée en pression trop élevée, on prévoit d'intégrer un dispositif anti-surpression, sous la forme d'une soupape de sécurité et/ou d'un affaiblissement maitrisé de l'épaisseur de la paroi (« burst disk »). De cette façon le risque d'explosion lors d'un incendie peut-être maitrisé. Préférentiellement le dispositif anti-surpression sera placé sur la partie supérieure de l'enveloppe étanche 20 de façon à éviter une évacuation liquide.

Ce fluide diélectrique **6** peut être choisi dans la gamme Novec™ de 3M®, par exemple pour ses qualités ignifuges.

Le fluide diélectrique **6** présente une température de vaporisation à la pression atmosphérique dans la gamme [45°C - 70°C]. Au contact des composants chauds, des bulles de vapeur **61** se forment (ce processus est communément appelé 'pool boiling') et remontent par la force d'Archimède vers le haut en direction de la paroi supérieure du bloc d'alimentation électrique ; à cet endroit, au contact de la paroi plus froide, elles subissent une condensation et retombent en gouttelettes **62** ou par ruissellement dans la masse principale du fluide diélectrique **6.**

Selon l'exemple illustré à la figure 1, le bloc d'alimentation électrique 2 présente une forme parallélépipédique, avec notamment une face supérieure qui forme une paroi d'échange thermique **3.**

Au sens de la présente invention, on désigne plus généralement la paroi d'échange thermique **3** par le terme 'zone d'échange thermique', cette zone étant pas nécessairement plane ou continue.

La paroi d'échange thermique **3** comprend, du côté dirigé vers l'intérieur de l'espace intérieur, des ailettes d'échange thermique **36,** qui augmentent la surface d'échange effective entre la phase vapeur du fluide diélectrique et la paroi d'échange thermique.

En lieu et place des ailettes représentées, il faut remarquer que tout type de surface d'échange thermique améliorée peut être choisi comme solution tendant à augmenter la surface d'échange efficace entre la phase vapeur du fluide diélectrique et la paroi d'échange thermique. Avantageusement, la structuration des ailettes permettra l'évacuation efficace du film de condensat.

De plus, on prévoit un circuit de transfert thermique diphasique **4** à pompage capillaire, configuré pour prélever des calories au niveau du bloc d'alimentation électrique et pour les rejeter à distance, ceci au moyen d'un fluide diphasique **14.**

Plus précisément, le circuit de transfert thermique diphasique **4** comprend un **échangeur-absorbeur 7** couplé thermiquement à la zone d'échange thermique **3** du bloc d'alimentation électrique, et un **échangeur-rejeteur 8,** situé à distance du bloc d'alimentation électrique, et couplé thermiquement à un collecteur général de calories **9.**

Par ailleurs, l'échangeur-absorbeur 7 et l'échangeur-rejeteur 8 sont reliés entre eux par des conduites (ou canalisations), une première conduite (réf **47)** transportant le fluide de travail depuis l'échangeur-absorbeur 7 vers l'échangeur-rejeteur 8 et l'autre (réf **48)** transportant le fluide de travail depuis l'échangeur-rejeteur 8 vers l'échangeur-absorbeur 7.

Selon l'exemple de la figure 1, l'échangeur-absorbeur **7** est formé par un évaporateur et l'échangeur-absorbeur **8** est formé par un condenseur (avec ou sans sous-refroidissement 'sub-cooling'), auquel cas la première conduite transporte essentiellement de vapeur **14V,** et la deuxième conduite transporte essentiellement du liquide **14L.**

Avantageusement, ces deux conduites **47,48** sont souples, ce qui permet de déplacer mécaniquement l'échangeur-absorbeur **7,** notamment pour procéder à l'extraction du bloc d'alimentation électrique comme il a été abordé dans l'introduction du présent document.

Dans la configuration normale de service (d'utilisation opérationnelle), la zone d'échange thermique **3** est plaquée contre l'échangeur-absorbeur **7,** à l'endroit d'une première interface repérée **IF1.** Selon la configuration 'à plat' représentée à la figure 1, la face inférieure l'échangeur-absorbeur **7** vient interfacer la face supérieure de la zone d'échange thermique **3** avec interposition (optionnelle) d'un matériau d'interface thermique **31** favorisant la conduction thermique entre la paroi d'échange thermique 3 et l'échangeur-absorbeur **7.** Le matériau d'interface thermique **31** est une graisse ou un composé graphité.

L'échangeur-rejeteur **8** permet d'évacuer des calories depuis le fluide de travail diphasique **14** vers un autre fluide caloporteur, ici un liquide froid **9** à base d'eau.

Selon une autre configuration représentée à la figure 2, l'équipement électronique 1 est un module carte serveur délimité par une enveloppe **10** de protection. Le bloc d'alimentation électrique **2** est normalement logé à l'intérieur de l'enveloppe **10,** mais il est représenté ici dans une position extraite, utile pour une opération de maintenance et/ou pour son remplacement.

Plus précisément, le bloc d'alimentation électrique est déplaçable entre une position de service et une position d'extraction comme il sera vu plus loin.

La paroi d'échange thermique **3** s'étend dans un plan **XY.** La direction **Z** correspond à la normale principale du module carte serveur.

L'échangeur-absorbeur **7** se retrouve, dans la position de service du bloc d'alimentation, au-dessus de ladite paroi d'échange thermique.

L'échangeur-rejeteur **8** est, dans l'exemple illustré, plaqué contre une des faces de l'enveloppe **10** du module (Fig. 2). Dans cette configuration, c'est l'ensemble de l'enveloppe **10** qui est utilisée comme élément radiatif des calories, et qui forme le collecteur général de calories au sens de la présente invention.

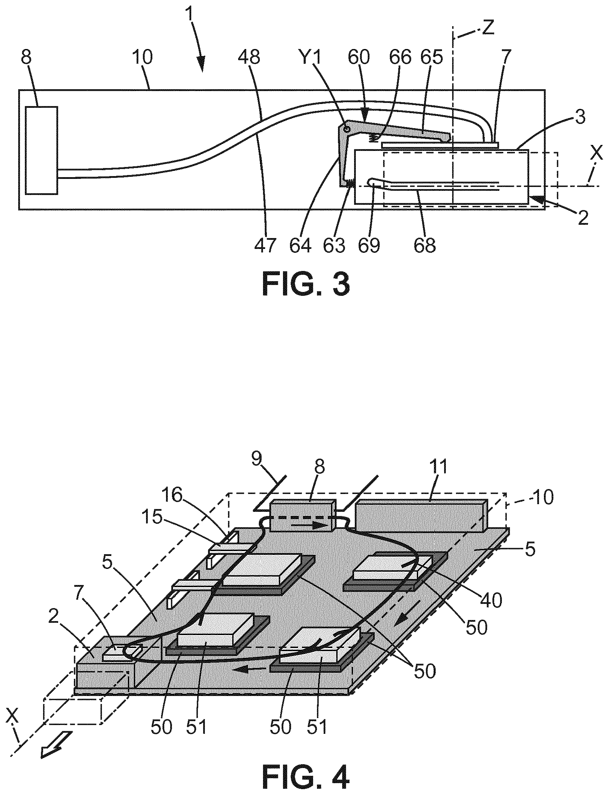

La figure 3 illustre deux solutions possibles, parmi d'autres, pour accoupler thermiquement l'échangeur-absorbeur **7** avec la paroi d'échange thermique du bloc d'alimentation électrique.

Selon une première solution, le mouvement d'insertion du bloc d'alimentation est rectiligne et parallèle à l'axe X, et l'échangeur-absorbeur est monté avec un degré de liberté de translation selon l'axe **Z.** Par ailleurs on prévoit un basculeur **60** monté à rotation autour d'un axe **Y1.** Lorsque le fond du bloc d'alimentation électrique s'approche de la position de fin de course, il appuie sur un ressort **63** qui pousse à son tour sur un premier bras de levier **64** du basculeur lequel pivote dans le sens des aiguilles d'une montre ; un second bras de levier **65** du basculeur vient pousser l'échangeur-absorbeur **7** contre la paroi d'échange thermique **3.** Lorsque l'on extrait le bloc d'alimentation électrique, un ressort de rappel **66** éloigne l'échangeur-absorbeur **7** de la position d'accouplement.

Selon une seconde solution, la glissière **68** qui guide le bloc d'alimentation électrique n'est pas rectiligne mais s'infléchit vers le haut en fin de course, avec une zone de rampe **69.** Dans ce cas, l'échangeur-absorbeur peut être monté en position quasiment fixe. À proximité de la fin de course, le bloc d'alimentation se rapproche de l'échangeur-absorbeur selon **Z** jusqu'à son contact, avec placage effectif en fin de course.

Un coupleur de connexion électrique (non représenté aux figures) permet alors au bloc d'alimentation électrique **2** de délivrer des alimentations stabilisées à destination des autres entités du module serveur **1.**

La figure 4 illustre une autre configuration du module carte serveur dans lequel le circuit de transfert thermique diphasique 4 collecte des calories sur une pluralité de composants dissipatifs présent sur la carte électronique, en particulier les processeurs principaux ('CPU' ou 'GPU') **50.** Sur chacun de ces processeurs est couplé thermiquement un évaporateur **51** relié à un circuit principal de collecte thermique **40.** Le circuit principal de collecte thermique **40** se présente sous la forme d'une boucle fermée par exemple annulaire avec du fluide de travail qui circule de façon passive (sans éléments mécaniques mobiles et consommation d'énergie extérieure) à l'intérieur, soit sous forme diphasique (liquide + vapeur), soit sous forme essentiellement liquide. Selon une configuration possible, la mise en mouvement du fluide de travail dans le circuit principal de collecte peut résulter d'un phénomène d'éjection de vapeur à la sortie de chacun des évaporateurs placés sur les processeurs principaux ; dans ces conditions, la présence d'une mèche capillaire dans l'échangeur-absorbeur **7** n'est pas strictement nécessaire.

Ce circuit principal de collecte thermique **40** alimente également en fluide de travail l'échangeur-absorbeur **7.**

On note que certains équipements secondaires tels que des barrettes mémoire **16** sont reliés au circuit principal de collecte **40** par un pont thermique conductif **15.**

Un coupleur de connexion électrique **11** permet de relier la carte électronique au châssis (connexion 'fond de rack' ou 'fond de panier').

S'agissant de l'échangeur-absorbeur **7,** il peut s'agir de plusieurs possibilités. Selon une première possibilité, il s'agit d'un évaporateur sans milieu capillaire, la circulation étant assurée par des mèches capillaires présentes dans les évaporateurs **51** de CPU comme mentionné plus haut.

Selon une seconde possibilité, il peut s'agir aussi d'un évaporateur avec milieu capillaire comme illustré à la figure 6, auquel cas il y a un moyen de pompage local.

Selon une troisième possibilité, il peut s'agir d'un échangeur de captation de calories utilisant le fluide de travail à l'état essentiellement liquide, le fluide étant utilisé principalement pour refroidir les CPUs par vaporisation et utilisé de manière annexe pour refroidir des équipements auxiliaires comme le bloc d'alimentation électrique, les barrettes mémoire, etc.

La figure 5 illustre une configuration avec les cartes électroniques 5 disposées verticalement, et le collecteur général de calories **9'** étant formé par un échangeur à air pulsé par un ventilateur **90.**

Une autre variante visible à la figure 5 illustre les positions relatives différentes pour d'une part le bloc d'alimentation électrique **2** et d'autre part l'échangeur-rejeteur **8.** Dans ce cas, l'échangeur-absorbeur **7** est un évaporateur capillaire, la mèche capillaire fournissant la pression de pompage passif à l'encontre de la gravité.

On remarque aussi que la paroi d'échange thermique du bloc d'alimentation électrique se situe sur un côté et non pas sur le dessus.

Ceci illustre la souplesse extrêmement importante pour l'implantation des différents éléments dans un équipement informatique.

Sur la figure 6, la mèche capillaire **71** est au contact de la plaque chaude **70.** Cette dernière présente des dents **72** qui délimitent des rainures **73** d'évacuation de la vapeur.

On prévoit des vis **76** de fixation rapide pour fixer la structure de l'évaporateur **78** sur la paroi d'échange thermique 3 du bloc d'alimentation électrique de l'évaporateur.

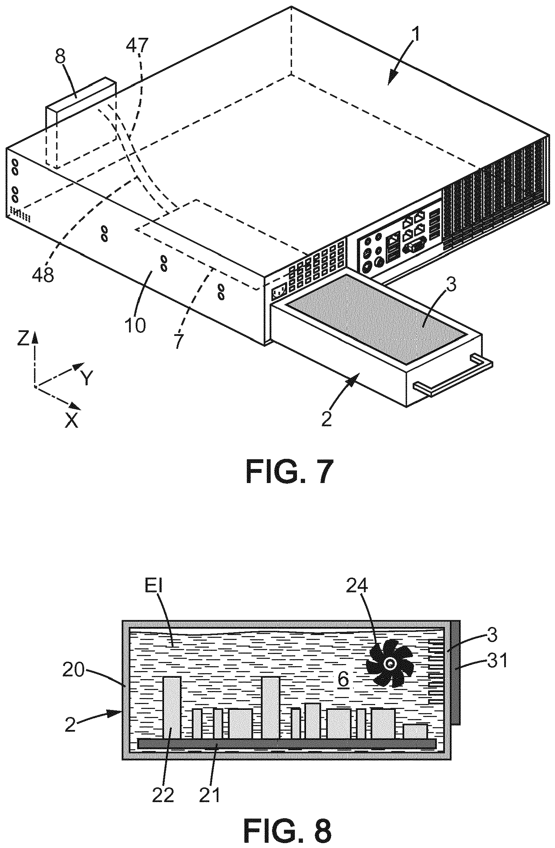

La figure 7 illustre une configuration similaire à celle déjà représentée sur la figure 3, selon laquelle le circuit de transfert thermique diphasique relie l'échangeur-absorbeur **7** au contact du bloc d'alimentation électrique avec l'échangeur-rejeteur **8** qui se trouve sur la face opposée, par exemple à côté du coupleur de connexion électrique **11.**

On note ici que la longueur des conduites **47,48** n'est pas contrainte, leur parcours n'est pas nécessairement rectiligne et peut faire des détours. On dispose ainsi avantageusement d'une grande liberté de positionnement tant pour le bloc d'alimentation électrique que pour la source froide destinée à le refroidir.

Dans les exemples présentés ci-dessus, on remarque que le fluide diélectrique **6,** typiquement du Novec™ de 3M®, remplit la cavité interne du bloc d'alimentation électrique 2, alors que le reste de la carte serveur n'est pas immergé dans du fluide électrique. Compte tenu du coût élevé de ce fluide diélectrique, cela permet de limiter le volume nécessaire pour un équipement serveur. Par exemple pour un module de carte serveur au standard 2U, le volume de fluide diélectrique utilisé dans le bloc alimentation électrique sera inférieur à 3 litre, et pour un module de carte serveur au standard 1Ule volume de fluide diélectrique utilisé dans le bloc alimentation électrique sera inférieur à 1 litre. Ceci est par conséquent avantageux par rapport à des solutions où la quasi-totalité de la carte du serveur est immergée.

La figure 8 illustre une variante concernant l'utilisation du fluide diélectrique **6** sans changement de phase comme par exemple une huile diélectrique. La convection naturelle n'est en général pas suffisamment efficace du fait de la forte viscosité de l'huile. On a dans ce cas une convection forcée par un dispositif de mise en mouvement du fluide comme par exemple une hélice **24.** Dans ce cas, le système perd son caractère totalement passif pour la partie interne du bloc d'alimentation électrique.

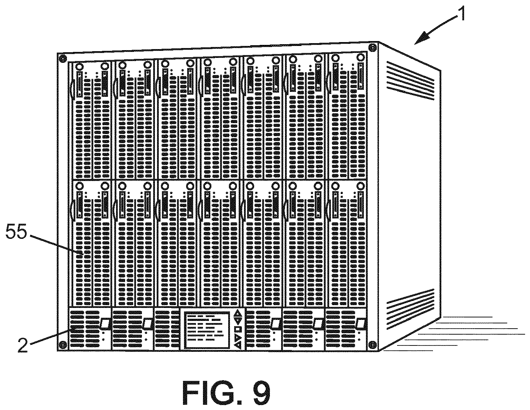

La figure 9 illustre une configuration d'armoires de modules serveurs **55** disposées verticalement, avec deux rangées l'une au-dessus de l'autre. En partie basse on retrouve des blocs de servitude comme le ou les blocs d'alimentation électrique **2** et le ou les coupleurs au réseau Internet.

On remarque qu'à la figure 1, il est prévu une interface repérée **IF2** grâce à laquelle on peut désaccoupler l'échangeur-rejeteur **8** et le collecteur général de calories **9.**

Dans une variante non représentée aux figures, on met à profit cette seconde interface **IF2** et on prévoit de former un macro module d'alimentation électrique qui intègre non seulement le bloc d'alimentation électrique **2** tel que décrit précédemment, mais aussi son propre circuit ('privé') de transfert thermique diphasique **4** avec ses conduites (optionnellement souples) et son échangeur rejeteur. Dans ce cas l'échangeur-absorbeur **7** peut être monté de manière non démontable sur la paroi d'échange thermique **3** du bloc d'alimentation électrique.

Outre les cartes serveurs de 'data centers', on peut bien entendu appliquer la solution proposée ci-dessus à des PC durcis destinés à être soumis à des environnements particulièrement sévères.

## Revendications

1. Equipement électronique ou informatique (1), comprenant :
- une ou plusieurs cartes électroniques (5) et le cas échéant des éléments auxiliaires,
- un bloc d'alimentation électrique (2), équipé d'une zone d'échange thermique (3), qui fournit des alimentations électriques à différentes entités de l'équipement électronique ou informatique (1), le bloc d'alimentation électrique ayant une enveloppe étanche (20) aux fluides définissant un espace intérieur (EI) empli de fluide diélectrique (6), apte à capter des calories sur divers composants du bloc d'alimentation électrique immergés dans le fluide pour les diffuser vers la zone d'échange thermique (3), le bloc d'alimentation électrique étant démontable et remplaçable,
- un circuit de transfert thermique diphasique (4) à pompage capillaire avec un échangeur-absorbeur (7) couplé thermiquement à la zone d'échange thermique du bloc d'alimentation électrique, et un échangeur-rejeteur (8), situé à distance du bloc d'alimentation électrique, et couplé thermiquement à un collecteur général de calories (9,9'), où, dans la position de service, la zone d'échange thermique (3) est plaquée contre l'échangeur-absorbeur (7), et **caractérisé en ce que** le reste de l'équipement électronique ou informatique n'est pas immergé dans le fluide diélectrique.

2. Equipement selon la revendication 1, dans lequel le circuit de transfert thermique diphasique (4) comprend un couple de deux conduites souples (47,48) reliant l'échangeur-absorbeur (7) et l'échangeur-rejeteur (8).

3. Equipement selon la revendication 2, dans lequel le couple de deux conduites comprend une conduite vapeur (47) et une conduite liquide (48).

4. Equipement selon l'une des revendications 1 à 3, dans lequel la zone d'échange thermique est formée par une ou plusieurs parois d'échange thermique formant une part de l'enveloppe étanche (20).

5. Equipement selon la revendication 4, dans lequel on prévoit un matériau d'interface thermique (31) favorisant la conduction thermique entre la paroi d'échange thermique (3) et l'échangeur-absorbeur (7).

6. Equipement selon l'une des revendications 1 à 5, dans lequel l'échangeur-absorbeur est un évaporateur dans lequel un fluide de travail diphasique est vaporisé par la chaleur apportée par la zone d'échange thermique (3).

7. Equipement selon la revendication 6, dans lequel l'évaporateur (7) comprend une masse poreuse (71) assurant la fonction de pompage capillaire.

8. Equipement selon la revendication 7, dans lequel l'évaporateur (7) est situé au-dessus de l'échangeur-rejeteur (8), la force motrice de pompage étant fournie par la pression capillaire à l'encontre de la gravité.

9. Equipement selon l'une des revendications 1 à 8, dans lequel la zone d'échange thermique (3) comprend, du côté dirigé vers l'intérieur de l'espace intérieur, une surface d'échange thermique améliorée, de préférence sous forme de projections de type ailettes (36) d'échange thermique.

10. Equipement électronique ou informatique selon l'une des revendications 1-9, sous la forme d'un module carte serveur informatique pour centre de de données ou de calcul, le bloc d'alimentation électrique ayant une forme générale parallélépipédique, reçu dans une glissière à l'intérieur d'une enveloppe (10) du module, la zone d'échange thermique étant formée par au moins une paroi d'échange thermique (3) .

11. Equipement selon la revendication 10, dans lequel la paroi d'échange thermique (3) s'étend dans un plan XY et on prévoit un mouvement selon la direction Z en fin de course d'insertion selon X, à proximité de la position de service, la glissière étant généralement perpendiculaire à Z.

12. Equipement selon l'une des revendications 1 à 11, dans lequel on prévoit une interface détachable (IF2) entre l'échangeur-rejeteur (8) et le collecteur général de calories (9).

13. Equipement selon l'une des revendications 1 à 12, dans lequel le volume de fluide diélectrique utilisé dans le bloc alimentation électrique est inférieur à 3 litres.

## Patentansprüche

1. Elektronische oder informationstechnische Einrichtung (1), aufweisend:
- eine oder mehrere Elektronikplatinen (5) und gegebenenfalls Hilfselemente,
- ein elektrisches Netzteil (2), das mit einer Wärmeaustauschzone (3) ausgestattet ist, die unterschiedlichen Einheiten der elektronischen oder informationstechnischen Einrichtung (1) Stromzufuhren bereitstellt, wobei das Netzteil ein fluiddichtes Gehäuse (20) aufweist, das einen Innenraum (EI) definiert, der mit dielektrischem Fluid (6) gefüllt ist, welches in der Lage ist, von diversen Komponenten des Netzteils, die in das Fluid getaucht sind, Wärme aufzunehmen, um sie in Richtung der Wärmeaustauschzone (3) zu diffundieren, wobei das Netzteil demontierbar und austauschbar ist,
- einen zweiphasigen Wärmeübertragungskreislauf (4) mit Kapillarpumpe, mit einem Austauscher-Absorber (7), der thermisch mit der Wärmeaustauschzone des Netzteils gekoppelt ist, und einem Austauscher-Ableiter (8), der sich beabstandet vom Netzteil befindet und thermisch mit einem allgemein kalorischen Sammler (9, 9') gekoppelt ist, wobei in der Betriebsstellung die Wärmeaustauschzone (3) gegen den Austauscher-Absorber (7) gedrückt wird, **dadurch gekennzeichnet dass** die restliche elektronische Einrichtung oder Computereinrichtung nicht in das dielektrische Fluid getaucht ist.

2. Einrichtung nach Anspruch 1, wobei der zweiphasige Wärmeübertragungskreislauf (4) ein Paar von zwei flexiblen Leitungen (47, 48) aufweist, die den Austauscher-Absorber (7) und den Austauscher-Ableiter (8) verbinden.

3. Einrichtung nach Anspruch 2, wobei das Paar von zwei Leitungen eine Dampfleitung (47) und eine Flüssigkeitsleitung (48) aufweist.

4. Einrichtung nach einem der Ansprüche 1 bis 3, wobei die Wärmeaustauschzone von einer oder mehreren Wärmeaustauschwänden gebildet wird, die einen Teil des dichten Gehäuses (20) bilden.

5. Einrichtung nach Anspruch 4, wobei ein thermisches Schnittstellenmaterial (31) vorgesehen ist, das die Wärmeleitung zwischen der Wärmeaustauschwand (3) und dem Austauscher-Absorber (7) begünstigt.

6. Einrichtung nach einem der Ansprüche 1 bis 5, wobei der Austauscher-Absorber ein Verdampfer ist, in dem ein zweiphasiges Arbeitsmedium durch die Wärme, die durch die Wärmeaustauschzone (3) eingetragen wird, verdampft wird.

7. Einrichtung nach Anspruch 6, wobei der Verdampfer (7) eine poröse Masse (71) aufweist, welche die Kapillarpumpfunktion sicherstellt.

8. Einrichtung nach Anspruch 7, wobei sich der Verdampfer (7) oberhalb des Austauscher-Ableiters (8) befindet, wobei die Pumpantriebskraft durch den Kapillardruck gegen die Schwerkraft bereitgestellt wird.

9. Einrichtung nach einem der Ansprüche 1 bis 8, wobei die Wärmeaustauschzone (3) auf der Seite, die dem Inneren des Innenraums zugewandt ist, eine verbesserte Wärmeaustauschoberfläche aufweist, vorzugsweise in Form von rippenartigen Wärmeaustauschvorsprüngen (36).

10. Elektronische Einrichtung oder Computereinrichtung nach einem der Ansprüche 1 bis 9 in Form eines Computer-Serverkartenmoduls für ein Daten- oder Rechenzentrum, wobei das Netzteil allgemein quaderförmig ist, aufgenommen in einer Gleitschiene im Inneren eines Gehäuses (10) der Baugruppe, wobei die Wärmeaustauschzone von mindestens einer Wärmeaustauschwand (3) gebildet wird.

11. Einrichtung nach Anspruch 10, wobei sich die Wärmeaustauschwand (3) in einer X-Y-Ebene erstreckt und am Ende des Einschubs in X-Richtung, in der Nähe der Betriebsstellung, eine Bewegung in die Z-Richtung vorgesehen ist, wobei die Gleitschiene im Wesentlichen senkrecht zur Z-Richtung ist.

12. Einrichtung nach einem der Ansprüche 1 bis 11, wobei zwischen dem Austauscher-Ableiter (8) und dem allgemeinen Wärmesammler (9) eine lösbare Schnittstelle (IF2) vorgesehen ist.

13. Einrichtung nach einem der Ansprüche 1 bis 12, wobei das Volumen des dielektrischen Fluids, das in dem Netzteil verwendet wird, unter 3 Litern liegt.

## Claims

1. Electronic or computer device (1) comprising:
- one or more circuit boards (5) and where appropriate auxiliary elements,
- a power supply unit (2), equipped with a heat exchange zone (3), which provides electrical power to various elements of the electronic or computer device (1), the power supply unit having a fluidtight enclosure (20) defining an interior space (EI) filled with dielectric fluid (6), capable of collecting heat from various components of the power supply unit immersed in the fluid in order to release it to the heat exchange zone (3), the power supply unit being removable and replaceable,
- a two-phase heat transfer circuit (4) with capillary pumped loop having an absorber-heat exchanger (7) thermally coupled to the heat exchange zone of the power supply unit, and a releaser-heat exchanger (8) located at a distance from the power supply unit and thermally coupled to a general thermal collector (9,9'), wherein when in the working position, the heat exchange zone (3) is pressed against the absorber-heat exchanger (7) **characterized in that** the rest of the electronic or computer device is not immersed in the dielectric fluid.

2. Device according to claim 1, wherein the two-phase heat transfer circuit (4) comprises a pair of two flexible hoses (47,48) connecting the absorber-heat exchanger (7) and the releaser-heat exchanger (8).

3. Device according to claim 2, wherein the pair of two hoses comprises a hose for vapor (47) and a hose for liquid (48).

4. Device according to one of claims 1 to 3, wherein the heat exchange zone is formed by one or more heat exchange walls forming part of the fluidtight enclosure (20).

5. Device according to claim 4, wherein a thermal interface material (31) facilitating heat conduction between the heat exchange wall (3) and the absorber-heat exchanger (7) is provided.

6. Device according to one of claims 1 to 5, wherein the absorber-heat exchanger is an evaporator in which a two-phase working fluid is vaporized by the heat supplied by the heat exchange zone (3).

7. Device according to claim 6, wherein the evaporator (7) comprises a porous mass (71) providing the capillary pumping function.

8. Device according to claim 7, wherein the evaporator (7) is located above the releaser-heat exchanger (8), the driving force being supplied by the capillary pumping pressure which overcomes gravity.

9. Device according to one of claims 1 to 8, wherein the heat exchange zone (3) comprises, on the side facing towards the interior space, an improved heat exchange surface, preferably in the form of fin-type heat exchange projections (36).

10. Electronic or computer device according to one of claims 1-9, in the form of a server board module for a data center or a computing center, the power supply unit having a generally parallelepiped shape, received in a slide guide inside an enclosure (10) of the module, the heat exchange zone being formed by at least one heat exchange wall (3).

11. Device according to claim 10, wherein the heat exchange wall (3) extends in an XY plane and a movement in the Z direction at the end of travel along X near the working position is provided, the slide guide being generally perpendicular to Z.

12. Device according to one of claims 1 to 11, wherein a detachable interface (IF2) is provided between the releaser-heat exchanger (8) and the general thermal collector (9).

13. Device according to one of claims 1 to 12, wherein the volume of the dielectric fluid used in the power supply unit (2) is less than 3 liters.
